# EUROPÄISCHE PATENTSCHRIFT

(11) **EP 3 553 812 B1**
(45) Veröffentlichungstag und Bekanntmachung des Hinweises auf die Patenterteilung: **31.12.2025**
(21) Anmeldenummer: 18166812.0
(22) Anmeldetag: 11.04.2018
(51) Int. Cl.: H01L 21/60, H01L 23/495, H01L 23/498, H01L 23/13

(54) **SUBSTRATANORDNUNG ZUR VERBINDUNG MIT EINEM ELEKTRONIKBAUTEIL**
ARRANGEMENT OF A SUBSTRATE FOR CONNECTION WITH AN ELECTRONIC COMPONENT
ENSEMBLE SUBSTRAT DESTINÉ À LA LIAISON À UN COMPOSANT ÉLECTRONIQUE

(43) Veröffentlichungstag der Anmeldung: 16.10.2019
(73) Patentinhaber: Heraeus Electronics GmbH & Co. KG, 63450 Hanau (DE)
(72) Erfinder: BECKER, Martin, 6430 Nordborg (DK); SCHEFUSS, Frank, 6430 Nordborg (DK); HINRICH, Andreas, 63450 Hanau (DE); KLEIN, Andreas Steffen, 63450 Hanau (DE)
(74) Vertreter: Heraeus IP

(56) Entgegenhaltungen:
- WO-A2-2017/060140
- US-A1- 2006 197 200
- US-A1- 2015 270 207

## Beschreibung

Die vorliegende Erfindung betrifft eine Substratanordnung zur Verbindung mit einem Elektronikbauteil. Weiterhin betrifft die vorliegende Erfindung ein Verfahren zur Herstellung einer Substratanordnung und ein Verfahren zum Verbinden mindestens eines Elektronikbauteils mit einer Substratanordnung.

In der Leistungselektronik ist es bekannt, Substrate mit einer vorapplizierten Kontaktierungsmittelschicht bereitzustellen, wie beispielsweise einer vorgetrockneten Sinterpaste. In einer höheren Fertigungsstufe werden die Substrate an Elektronikbauteile, wie beispielsweise Leistungstransistoren, angeheftet und danach gesintert. Es hat sich herausgestellt, dass ein Anhaften der Substrate mit der vorapplizierten Sinterschicht mit oder ohne gleichzeitiger Wärmebeaufschlagung nur eine unzureichende Transportfestigkeit ermöglicht, da die Adhäsion zwischen Substrat und Elektronikbauteil nicht ausreicht, um einen sicheren Transport vom Ort des Bestückens zum Ort des Sinterns zu ermöglichen.

Damit das Substrat beim Transport vom Ort des Bestückens zum Ort des Sinterns nicht auf dem Elektronikbauteil verrutscht, ist es aus dem Stand der Technik bekannt das Substrat an die Elektronikbauteile mittels eines Vorfixiermittels, das auf einer von dem Substrat abgewandten Seite der Kontaktierungsmittelschicht und/oder auf dem Substrat auf der gleichen Seite wie auch die Kontaktierungsmittelschicht angeordnet ist für den Transport zu fixieren. Beispielsweise beschreibt die WO 2017/060140 A2 das Anbringen eines solchen Vorfixiermittels, um ein Verrutschen beim Transport zu verhindern. Das beschriebene Vorfixiermittel umfasst mindestens eine organische Verbindung, wie ein Lösemittel und/oder ein Polymer, um eine gute Fixierung an dem Elektronikbauteil zu erreichen.

US 2015/0270207 A1 bezieht sich auf ein Halbleitermodul-Package und ein Verfahren zur Herstellung desselben. Das Halbleitermodul-Package umfasst einen Lead Frame der auf dem Halbleiterbauelement angeordnet ist und mit Öffnungen, durch die Lotpaste zur Kontaktierung eingefüllt werden kann.

US 2006/0197200 A1 (siehe Abb.23) beschreibt ein Verfahren zur Verbindung eines Elektronikbauteils mit einem mit Durchgangsöffnungen vorgesehen Substrat durch verschieden Verbindungsmittel.

Auch wenn durch ein derartiges Vorfixiermittel ein Verrutschen des Substrats relativ zu dem Elektronikbauteil im Wesentlichen verhindert werden kann, so besteht ein Nachteil des bekannten Stands der Technik darin, dass Anteile oder Reste des Vorfixiermittels nach dem Sintern die Sinterverbindung negativ beeinflussen können, indem die Haltbarkeit und/oder die Lebensdauer der Sinterverbindung herabgesetzt werden. Weiterhin können seitlich austretende Anteile oder Reste des Vorfixiermittels zwischen Substrat und Elektronikbauteil die gegenüberliegenden Seite des Substrats, die oftmals zur Kontaktierung beispielsweise mittels mindestens eines Bonddrahtes dient, Verunreinigen und somit den zur Verfügung stehenden Kontaktbereich reduzieren und/oder die Qualität der Bondverbindung herabsetzen. Auch können die austretenden Reste benachbarte Bereiche auf dem Elektronikbauteil verunreinigen und im schlimmsten Fall das Elektronikbauteil zerstören.

Aufgabe der vorliegenden Erfindung ist es daher, eine verbesserte Substratanordnung zur Verbindung mit einem Elektronikbauteil, ein Verfahren zur Herstellung einer Substratanordnung und ein Verfahren zum Verbinden eines Elektronikbauteils mit einer Substratanordnung bereitzustellen.

Diese Aufgabe wird erfindungsgemäß hinsichtlich der verbesserten Substratanordnung durch eine Substratanordnung gemäß des Gegenstands des Patentanspruchs 1 gelöst. Die erfindungsgemäße Substratanordnung zur Verbindung mit einem Elektronikbauteil weist hierfür auf:
zumindest ein Substrat mit einer ersten Seite und einer der ersten Seite gegenüberliegenden zweiten Seite;
zumindest eine Kontaktierungsmittelschicht, angeordnet zumindest abschnittsweise auf der ersten Seite des Substrats; und
   zumindest ein Vorfixiermittel, angeordnet zumindest abschnittsweise auf einer vom Substrat abgewandten Seite der Kontaktierungsmittelschicht und/oder zumindest abschnittsweise auf der ersten Seite des Substrats, und wobei das Substrat zumindest eine Durchgangsöffnung mit einer ersten Öffnung und einer zweiten Öffnung von der ersten Seite zur gegenüberliegenden zweiten Seite aufweist und wobei das Vorfixiermittel eine Vorfixiermittelzusammensetzung ist und die folgenden Bestandteile aufweist,
      - 0 bis 97 Gew.-% mindestens eines Lösemittels ausgewählt aus der Gruppe bestehend aus Wasser und organischen Lösemitteln,
      - 3 bis 100 Gew.-% mindestens eines im Bereich von 30 bis 180°C schmelzenden Materials M ausgewählt aus der Gruppe bestehend aus (i) im Bereich von 30 bis 180°C schmelzenden organischen Verbindungen, (ii) im Bereich von 30 bis 180°C schmelzenden Gemischen organischer Substanzen und (iii) organischen Polymeren,
      - 0 bis 20 Gew.-% mindestens eines vom mindestens einen im Bereich von 30 bis 180°C schmelzenden Material M verschiedenen organischen freien Additivs, und
      - 0 bis 30 Gew.-% eines oder mehrerer anorganischer fester Füllstoffe,
   wobei sich die Gew.-% zu 100 Gew.-% addieren.

In diesem Zusammenhang kann der Begriff "Elektronikbauteil" verwendet werden, um ein elektronisches, beziehungsweise elektrisches Bauelement, zu bezeichnen. Der Begriff "Elektronikbauteil" kann daher Bauelemente umfassen, die in der Leistungselektronik verwendet werden, wie beispielsweise einen Leistungstransistor. In einem Beispiel kann die erfindungsgemäße Substratanordnung mit dem Elektronikbauteil verwendet werden. In einem weiteren Beispiel der Erfindung kann die erfindungsgemäße Substratanordnung das Elektronikbauteil umfassen.

Der Begriff "Kontaktierungsmittelschicht" kann dazu verwendet werden eine Schicht zu bezeichnen, die zumindest ein Kontaktierungsmaterial umfasst, wie beispielsweise ein Sintermaterial, das eine Sinterpaste, ein Lot, einen Leitkleber oder ein sonstiges Klebemittel umfassen kann, um das Substrat mit dem Elektronikbauteil dauerhaft und zuverlässig zu verbinden. Abhängig von dem verwendeten Kontaktierungsmaterial kann zur Herstellung der endgültigen Verbindung eine Temperatur- und/oder Druckbehandlung, wie beispielsweise ein Sintervorgang notwendig sein. Die Kontaktierungsmittelschicht kann vollflächig, oder abschnittswiese, auf die erste Seite des Substrates angeordnet sein und kann eine Schichtdicke von 5 - 500 µm aufweisen.

Das Vorfixiermittel dient zur Vorfixierung bzw. zu einem vorübergehenden Anheften des Substrats an dem Elektronikbauteil oder des Elektronikbauteils an dem Substrat. Aufgrund des Vorfixierens bzw. Anheftens soll eine ausreichende Transportfähigkeit des Bauteils vom Ort des Bestückens zum Ort der Weiterverarbeitung als auch beim Weiterverarbeiten an sich, wie beispielsweise dem Sintern erreicht werden. In diesem Zusammenhang ist, als "Vorfixiermittel" ein temporäres oder lösbares Fixiermittel zu verstehen, das zumindest eine vorübergehende Fixierung einer Substratanordnung bzw. eines Substrates mit einem Elektronikbauteil ermöglicht. Das Vorfixiermittel kann beispielsweise eine organische Verbindung, wie ein Lösemittel oder ein Polymer, umfassen, um ein Anheften zu ermöglichen.

Das Vorfixiermittel wird aus einer Vorfixiermittelzusammensetzung appliziert. Diese Vorfixiermittelzusammensetzung weist die nachfolgenden Bestandteile auf:
0 bis 97 Gew.-% mindestens eines Lösemittels ausgewählt aus der Gruppe bestehend aus Wasser und organischen Lösemitteln,
3 bis 100 Gew.-% mindestens eines im Bereich von 30 bis 180°C schmelzenden Materials M ausgewählt aus der Gruppe bestehend aus (i) im Bereich von 30 bis 180°C schmelzenden organischen Verbindungen, (ii) im Bereich von 30 bis 180°C schmelzenden Gemischen organischer Substanzen und (iii) organischen Polymeren,
0 bis 20 Gew.-% mindestens eines vom mindestens einen im Bereich von 30 bis 180°C schmelzenden Material M verschiedenen organischen freien Additivs, und
0 bis 30 Gew.-% eines oder mehrerer anorganischer fester Füllstoffe,
wobei sich die Gew.-% zu 100 Gew.-% addieren können.

Die hierin verwendeten Begriffe "organische Verbindung", "organische Substanz", "organisches Polymer" und "organisches Additiv" können auch Stoffe mit organischen und anorganischen Anteilen umfassen; lediglich rein anorganische Stoffe sind von den Begriffen nicht umfasst.

Entsprechend ihres Gehaltes von 0 bis 97 Gew.-% mindestens eines Lösemittels ausgewählt aus der Gruppe bestehend aus Wasser und organischen Lösemitteln kann es sich bei der Vorfixiermittelzusammensetzung, aus der das Vorfixiermittel appliziert wird, um eine lösemittelfreie, um eine wässrige von organischem Lösemittel freie, um eine wässrige organisches Lösemittel enthaltende oder um eine nichtwässrige organisches Lösemittel enthaltende Zusammensetzung handeln.

Beispiele für lösemittelfreie Vorfixiermittelzusammensetzungen sind beim Applizieren feste bis klebrige Vorfixiermittelzusammensetzungen, beispielsweise in Form von Folie, Strang, Pulver, Tropfen, Hotmelt-Material, öligem oder harzartigem Material. Abhängig von der Konsistenz einer betreffenden lösemittelfreien Fixiermittelzusammensetzung wird der Fachmann ein zum Applizieren geeignetes Verfahren auswählen.

Beispiele für wässrige Fixiermittelzusammensetzungen sind wässrige von organischem Lösemittel freie oder wässrige organisches Lösemittel enthaltende Vorfixiermittelzusammensetzungen. Dabei kann es sich um Lösungen, Suspensionen oder Dispersionen handeln, deren rheologisches Verhalten in einem breiten Bereich vom flüssigen bis zum pastösen Zustand liegen kann. Dementsprechend können die wässrigen Vorfixiermittelzusammensetzungen auf verschiedene Art appliziert werden, beispielsweise durch Jetten, Dispensen, Sprühen, Pinseln, Tupfen, Tauchen oder Drucken, gefolgt von einer Trocknung zwecks weitgehender bis bevorzugt vollständiger Entfernung des Wassers und des gegebenenfalls enthaltenen organischen Lösemittels.

Bei nichtwässrigen organisches Lösemittel enthaltenden Vorfixiermittelzusammensetzungen kann es sich um Lösungen, Suspensionen oder Dispersionen handeln, deren rheologisches Verhalten in einem breiten Bereich vom flüssigen bis zum pastösen Zustand liegen kann. Dementsprechend können die nichtwässrigen organisches Lösemittel enthaltenden Vorfixiermittelzusammensetzungen auf verschiedene Art appliziert werden, beispielsweise durch Jetten, Dispensen, Sprühen, Pinseln, Tupfen, Tauchen oder Drucken, gefolgt von einer Trocknung zwecks weitgehender bis bevorzugt vollständiger Entfernung des organischen Lösemittels.

Bevorzugt als das mindestens eine im Bereich von 30 bis 180°C schmelzende Material M sind organische Polymere, insbesondere teil- oder vollsynthetische organische Polymere.

Bevorzugte Beispiele für im Bereich von 30 bis 180°C schmelzende organische Verbindungen sind Lactame wie beispielsweise Laurinlactam; und Fettalkohole wie beispielsweise 1-Dodecanol (Laurylalkohol), 1-Tetradecanol (Myristylalkohol), 1-Hexadecanol (Cetylalkohol), 1-Heptadecanol (Margarylalkohol), 1-Octadecanol (Stearylalkohol), 1-Eicosanol (Arachidylalkohol), 1-Docosanol (Behenylalkohol), 1-Tetracosanol (Lignocerylalkohol), 1-Hexacosanol (Cerylalkohol), 1-Octacosanol (Montanylalkohol), 1-Triacontanol (Melissylalkohol).

Bevorzugte Beispiele für im Bereich von 30 bis 180°C schmelzende Gemische organischer Substanzen sind entsprechende Öle, Fette, Wachse, beispielsweise natürliche Wachse wie beispielsweise Bienenwachs, Paraffinwachse und Vaseline.

Beispiele für organische Polymere sind neben den bevorzugten Thermoplasten härtbare Polymere. Stofflich besteht für das oder die organischen Polymere keine Beschränkung. Es kann sich beispielsweise um Vinylcopolymere, (Meth)acrylcopolymere, Polyester, Polyurethane, Polymervorläufer solcher vorerwähnten Polymere und/oder um Cellulosederivate wie beispielsweise Celluloseether und -ester handeln. Besonders bevorzugt sind (Meth)acrylcopolymere und Cellulosederivate wie Methylcellulose oder Ethylcellulose.

Der hierin verwendete Ausdruck "organische Polymere" umfasst auch organische Oligomere. Die organischen Polymere haben eine gewichtsmittlere Molmasse Mw beispielsweise im Bereich von 1000 bis 300.000, bestimmbar mittels GPC (Gelpermeationschromatographie, Polystyrolstandandards, Polystyrolgel als stationäre Phase, Tetrahydrofuran als mobile Phase).

Die Vorfixiermittelzusammensetzung kann 0 bis 20 Gew.-% mindestens eines vom mindestens einen im Bereich von 30 bis 180°C schmelzenden Material M verschiedenen organischen freien Additivs enthalten, beispielsweise Härter, Benetzungsadditive, Rheologieadditive, Katalysatoren, Fotoinitiatoren.

Die Vorfixiermittelzusammensetzung kann 0 bis 30 Gew.-% eines oder mehrerer anorganischer fester Füllstoffe enthalten. Beispiele für anorganische feste Füllstoffe sind Siliziumdioxid und Aluminiumoxid.

Aus der Vorfixiermittelzusammensetzung appliziertes Vorfixiermittel kann sich in seiner Zusammensetzung qualitativ und/oder quantitativ von der der Vorfixiermittelzusammensetzung unterscheiden. Dies kann beispielsweise Folge seiner Applikation und/oder einer im Rahmen seiner Applikation bewusst durchgeführten Entfernung von Lösemittel oder Trocknung und/oder thermischen und/oder photochemischen Behandlung sein. Im Falle eines aus einer Lösemittel enthaltenden Vorfixiermittelzusammensetzung applizierten Vorfixiermittels ist dessen Lösemittelanteil relativ zu dem der Vorfixiermittelzusammensetzung um >50 bis 100 Gew.-%, bevorzugt um >80 bis 100 Gew.-% reduziert. Mit anderen Worten, im Vergleich zur lösemittelhaltigen Vorfixiermittelzusammensetzung ist im applizierten Vorfixiermittel mehr als die Hälfte, bevorzugt mehr als 80 Gew.-% des ursprünglich in der lösemittelhaltigen Vorfixiermittelzusammensetzung enthaltenen Lösemittels entfernt.

Erfindungsgemäß weist das Substrat zumindest eine Durchgangsöffnung mit einer ersten Öffnung und einer zweiten Öffnung von der ersten Seite zur gegenüberliegenden zweiten Seite auf. Unter dem Begriff "Durchgangsöffnung" kann eine Ausnehmung in dem Material des Substrats verstanden werden, die sich von der ersten Öffnung auf der Seite des Substrats zu der zweiten Öffnung auf der zweiten Seite des Substrats erstreckt. Dabei können Öffnungen unterschiedliche Größen und Geometrien haben. Vorzugsweise weist das Substrat mehrere Durchgangsöffnungen auf. Beispielsweise kann eine Anzahl von Durchgangsöffnungen einer Anzahl von Vorfixiermittelpunkten entsprechen.

Die Durchgangsöffnung/Durchgangsöffnungen und deren Öffnungen können beispielsweise zylindrisch, rund, rechteckig, oval, elliptisch oder rechteckig mit abgerundeten Ecken ausgestaltet sein.

Der Erfindung liegt somit die überraschende Erkenntnis zu Grunde, dass sich Anteile oder Reste des Vorfixiermittels bei einer Temperatur- und/oder Druckbehandlung, wie beispielsweise einem Sintervorgang, verflüssigen und gezielt in die Durchgangsöffnung durch die Kapillarwirkung der Durchgangsöffnung aufgenommen werden können, um dadurch ein unkontrollierbares Austreten der Anteile oder Reste des Vorfixiermittels zu vermeiden. Bei den Anteilen oder Resten des Vorfixiermittels kann es sich beispielsweise um das Material M und/oder andere organische vom Material M verschiedene Additive handeln.

Mit der Erfindung ist es erstmalig gelungen eine Lösung bereitzustellen, die bei dem Einsatz von insbesondere organischen Vorfixiermitteln, den unkontrollierten Austritt des organischen Vorfixiermittels oder Anteile bzw. Reste desselbigen während einer Temperatur- und/oder Druckbehandlung zum dauerhaften Verbinden des Substrats mit dem Elektronikbauteil verhindert. Die Anteile oder Reste des Vorfixiermittels, die gewöhnlich während der Temperatur- und/oder Druckbehandlung in eine flüssige Phase übergehen, können in die Durchgangsöffnung aufgenommen werden und somit räumlich festgehalten werden, so dass die Anteile oder Reste des Vorfixiermittels innerhalb von funktionalen Stellen, wie beispielsweise auf dem Elektronikbauteil oder innerhalb des Verbindungsbereichs der Kontaktierungsmittelschicht zu keinen oder weniger Störungen führen.

In einem Beispiel weist das Substrat eine Vielzahl von Durchgangsöffnungen von der ersten Seite zur gegenüberliegenden zweiten Seite auf, bevorzugt weist das Substrat Durchgangsöffnungen an einem Randbereich des Substrats auf.

Wie bereits beschrieben können die Durchgangsöffnungen unterschiedliche Größen und Geometrien haben. Hier kann, abhängig von der spezifischen Anwendung und der Menge des verwendeten Vorfixiermittels, die Länge der Durchgangsöffnung(en) so gewählt werden, dass eine definierte Menge der flüssig werdende Anteile oder Reste des Vorfixiermittels bei einer Temperatur- und/oder Druckbehandlung in die Durchgangsöffnungen aufgenommen werden. Die Breite kann so klein gewählt werden, dass die notwendige Kapillarkraft entsteht, um die Anteile oder Reste des Vorfixiermittels gegen die Gravitationskraft nach oben steigen zu lassen.

Vorteilhaft bietet eine Anordnung der Durchgangsöffnungen an einem Randbereich des Substrats einen effizienten Schutz vor auslaufendem Vorfixiermittel. Beispielsweise können auch mehrere längliche Durchgangsöffnungen im Wesentlichen parallel zum Rand des Substrats verlaufen und hintereinander angeordnet sein, um den Schutz vor einem Auslaufen des Vorfixiermittels bei einer Temperatur- und/oder Druckbehandlung weiter zu steigern.

In einem weiteren Beispiel ist die erste Öffnung der Durchgangsöffnung oder der Durchgangsöffnungen an der ersten Seite des Substrats zumindest bereichsweise an dem Vorfixiermittel angeordnet, und/oder steht mit dem Vorfixiermittel in Verbindung, und/oder ist zumindest bereichsweise an einem Bereich der ersten Seite des Substrats angeordnet der zumindest bereichsweise weder von dem Vorfixiermittel noch von der Kontaktierungsmittelschicht bedeckt ist.

Unter dem Begriff "bereichsweise an dem Vorfixiermittel angeordnet" kann ein Anordnen des Vorfixiermittels an und/oder auf der ersten Öffnung der Durchgangsöffnung verstanden werden, beispielsweise kann das Vorfixiermittel auf/in der ersten Öffnung angeordnet, zum Beispiel aufgedruckt, sein. Vorteilhaft, kann hierdurch eine vordefinierte Menge Vorfixiermittel angeordnet werden, um ein ausreichendes Vorfixieren bzw. Anheften während des Transports der Substratanordnung aufgebracht auf das Elektronikbauteil zu ermöglichen und bei einer Temperatur- und/oder Druckbehandlung sofort in die Durchgangsöffnung aufgenommen zu werden ohne weitere Bereiche des Substrats und/oder des Elektronikbauteils zu verunreinigen und/oder die Kontaktierungsmittelschichtverbindung zu beinträchtigen.

Unter dem Begriff "steht mit dem Vorfixiermittel in Verbindung" kann ein "in Zusammenhang stehen" verstanden werden, wobei die erste Öffnung direkt oder indirekt mit dem Vorfixiermittel in Zusammenhang stehen kann. Beispielsweise kann ein Luftspalt zwischen der ersten Öffnung und dem Vorfixiermittel vorhanden sein, und/oder es können Anteile der Kontaktierungsmittelschicht zwischen der ersten Öffnung und dem Vorfixiermittel vorhanden sein.

In einem Beispiel ist die Geometrie der Durchgangsöffnung über den Verlauf von der ersten Öffnung zu der zweiten Öffnung im Wesentlichen konstant ausgebildet, oder
die Geometrie der Durchgangsöffnung ist über den Verlauf von der ersten Öffnung zu der zweiten Öffnung verkleinernd, insbesondere graduell verkleinernd, oder stufenweise verkleinernd, ausgebildet.

Vorteilhaft kann bei einem sich verkleinernden oder verjüngenden Verlauf der Durchgangsöffnung von der ersten Öffnung bis hin zur zweiten Öffnung ausreichend Volumen für die Aufnahme einer definierten Menge der flüssig werdenden Anteile oder Reste des Vorfixiermittels bei einer Temperatur- und/oder Druckbehandlung in die Durchgangsöffnung bei einer fast vollständig geschlossenen Oberfläche der zweiten Seite des Substrats bereitgestellt werden. In diesem Beispiel ist die zweite Öffnung lediglich so groß gewählt, dass ein Kapillareffekt eintritt und der wesentliche Anteil oder Rest des flüssigen Vorfixiermittels wird in der so entstandenen hohlraumähnlichen Ausnehmung in dem Material des Substrats gesammelt.

In einem weiteren Beispiel ist die Durchgangsöffnung im Wesentlichen rechteckig ausgestaltet und weist eine Breite von 10-100 µm, bevorzugt 20-70 µm, auf, und/oder ein Volumen der Durchgangsöffnung beträgt mindestens 5% des Volumens des Vorfixiermittels.

In diesem Zusammenhang kann unter dem Begriff "Rechteckig" auch "Schlitzförmig" verstanden werden. Besonders gute Ergebnisse können mit einem schmalen aber entsprechend langen Schlitz als Durchgangsöffnung erzielt werden, der sich in dem Material des Substrats ausdehnt und in den das flüssige Vorfixiermittel schnell aufgenommen werden kann.

Überraschenderweise hat sich herausgestellt, dass das Volumen der Durchgangsöffnung/Durchgangsöffnungen im Wesentlichen nur 5% bis 80% des Volumens des Vorfixiermittels betragen sollte, um die flüssig werdenden Anteile oder Reste des Vorfixiermittels im Wesentlichen vollständig aufnehmen zu können, da ein beträchtlicher Teil des Vorfixiermittels verdampft und/oder sich anderweitig verflüchtigt.

In noch einem Beispiel umfasst die Kontaktierungsmittelschicht Metallpartikel, insbesondere Silberpartikel, und das Vorfixiermittel umfasst zumindest eine organische Komponente, insbesondere zumindest ein Lösemittel und/oder zumindest ein Polymer.

Weiterhin kann das Kontaktierungsmaterial der Kontaktierungsmittelschicht Bindemittel und/oder Fettsäuren umfassen. Bei den Bindemitteln kann es sich insbesondere um Polymere wie Zellulose-Derivate, beispielsweise Methylzellulose, Ethylzellulose, Ethylmethylzellulose, Carboxyzellullose und Hydroxypropylzellullose handeln. Bei den Fettsäuren kann es sich insbesondere um Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) handeln.

In einem weiteren Beispiel ist die Kontaktierungsmittelschicht auf einer Fläche der ersten Seite des Substrats angeordnet, und bildet einen kontaktierungsmittelfreien Bereich, insbesondere einen Rand, auf der ersten Seite des Substrats aus, der frei von der Kontaktierungsmittelschicht ist, und
das Vorfixiermittel ist zumindest abschnittsweise auf dem kontaktierungsmittelfreien Bereich angeordnet, insbesondere punktförmig angeordnet.

Vorteilhaft kann durch eine Anordnung des Vorfixiermittels zumindest abschnittsweise um das Kontaktierungsmittel auf der ersten Seite des Substrats ein ausreichendes Anheften des Substrats an das Elektronikbauteil für den Transport und eine im Wesentlichen verunreinigungsfreie Kontaktierungsmittelschicht, beispielsweise Sinterschicht, nach der Temperatur- und/oder Druckbehandlung erzielt werden.

In noch einem weiteren Beispiel umfasst das Substrat ein Metallblech oder Metallbandabschnitt, insbesondere ein Kupferblech oder ein Kupferblechabschnitt, oder ein Leadframe oder ein DCB - oder PCB -Substrat, und/oder das Substrat ist auf der ersten und/oder zweiten Seite mit einem Material das Gold (Au), Nickel-Gold (NiAu), Silber (Ag), Nickel-Silber (NiAg) und/oder Nickel-Palladium-Gold (NiPdAu) umfasst beschichtet, insbesondere galvanisiert oder chemisch abgeschieden.

Vorteilhaft kann durch eine entsprechende Beschichtung und/oder Materialwahl des Substrats und einer Anordnung des Substrats auf dem Elektronikbauteil, bzw. auf einem Kontakt des Elektronikbauteils, eine verbesserte Kontaktierung des Kontakts, beispielsweise mittels eines Bonddrahtes ermöglicht werden.

Die Erfindung schlägt auch ein Verfahren zur Herstellung einer Substratanordnung zur Verbindung mit einem Elektronikbauteil vor, aufweisend die Schritte:
Bereitstellen zumindest eines Substrats mit einer ersten Seite und einer der ersten Seite gegenüberliegenden zweiten Seite, wobei das Substrat zumindest eine Durchgangsöffnung mit einer ersten Öffnung und einer zweiten Öffnung von der ersten Seite zur gegenüberliegenden zweiten Seite aufweist;
Aufbringen zumindest einer Kontaktierungsmittelschicht zumindest abschnittsweise auf der ersten Seite des Substrats; und
   Aufbringen zumindest einer Vorfixiermittelzusammensetzung zumindest abschnittsweise auf einer vom Substrat abgewandten Seite der Kontaktierungsmittelschicht und/oder Aufbringen der Vorfixiermittelzusammensetzung zumindest abschnittsweise auf der ersten Seite des Substrats und wobei das Vorfixiermittel eine Vorfixiermittelzusammensetzung ist, und die folgenden Bestandteile aufweist,
      - 0 bis 97 Gew.-% mindestens eines Lösemittels ausgewählt aus der Gruppe bestehend aus Wasser und organischen Lösemitteln,
      - 3 bis 100 Gew.-% mindestens eines im Bereich von 30 bis 180°C schmelzenden Materials M ausgewählt aus der Gruppe bestehend aus (i) im Bereich von 30 bis 180°C schmelzenden organischen Verbindungen, (ii) im Bereich von 30 bis 180°C schmelzenden Gemischen organischer Substanzen und (iii) organischen Polymeren,
      - 0 bis 20 Gew.-% mindestens eines vom mindestens einen im Bereich von 30 bis 180°C schmelzenden Material M verschiedenen organischen freien Additivs, und
      - 0 bis 30 Gew.-% eines oder mehrerer anorganischer fester Füllstoffe,
   wobei sich die Gew.-% zu 100 Gew.-% addieren.

In einem Beispiel weist das Bereitstellen des Substrats auf:
Einbringen zumindest einer, bevorzugt einer Vielzahl von Durchgangsöffnungen, insbesondere durch Ätzen, Stanzen und/oder einem Laser/Wasserstrahl, von der ersten Seite des Substrats zur gegenüberliegenden zweiten Seite des Substrats, bevorzugt Einbringen der Durchgangsöffnungen an einem Randbereich des Substrats.

In noch einem Beispiel ist die erste Öffnung der Durchgangsöffnung oder der Durchgangsöffnungen an der ersten Seite des Substrats zumindest bereichsweise an dem Vorfixiermittel angeordnet, und/oder steht mit dem Vorfixiermittel in Verbindung, und/oder ist zumindest bereichsweise an einem Bereich der ersten Seite des Substrats angeordnet der zumindest bereichsweise weder von dem Vorfixiermittel noch von der Kontaktierungsmittelschicht bedeckt ist.

In einem weiteren Beispiel ist die Geometrie der Durchgangsöffnung über den Verlauf von der ersten Öffnung zu der zweiten Öffnung im Wesentlichen konstant ausgebildet, oder
die Geometrie der Durchgangsöffnung ist über den Verlauf von der ersten Öffnung zu der zweiten Öffnung verkleinernd, insbesondere graduell verkleinernd, oder stufenweise verkleinernd, ausgebildet.

In noch einem weiteren Beispiel ist die Durchgangsöffnung im Wesentlichen rechteckig ausgestaltet und weist eine Breite von 10-100µm, bevorzugt 20-70µm, auf, und/oder ein Volumen der Durchgangsöffnung beträgt mindestens 5% des Volumens des Vorfixiermittels.

Weiterhin schlägt die Erfindung auch ein Verfahren vor zum Verbinden mindestens eines Elektronikbauteils mit einer erfindungsgemäßen Substratanordnung und/oder mit einer Substratanordnung hergestellt nach dem erfindungsgemäßen Verfahren, aufweisend die Schritte:
Positionieren der Substratanordnung auf dem Elektronikbauteil mit der ersten Seite in Richtung des Elektronikbauteils;
Vorfixieren der Substratanordnung auf dem Elektronikbauteil durch das Vorfixiermittel auf der ersten Seite des Substrats; und
Verbinden der Substratanordnung mit dem mindestens einen Elektronikbauteil.

In einem Beispiel weist das Verbinden auf:
Versintern, Verpressen, Verlöten, und/oder Verkleben der Substratanordnung mit dem Elektronikbauteil, wobei während dem Verbinden Anteile oder Reste des Vorfixiermittels in die Durchgangsöffnung des Substrats aufgenommen werden, und/oder aus der Durchgangsöffnung auf der zweiten Seite des Substrats hindurchtreten.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

Dabei zeigt:
- Figur 1: eine Draufsicht auf eine aus dem Stand der Technik bekannte Substratanordnung verbunden mit einem Elektronikbauteil;
- Figur 2: eine schematische Schnittansicht einer Substratanordnung gemäß einer Ausführungsform der Erfindung verbunden mit einem Elektronikbauteil, vor dem Sintern; und
- Figur 3a, 3b: eine schematische Schnittansicht und eine Detailansicht einer Substratanordnung gemäß einer Ausführungsform der Erfindung verbunden mit einem Elektronikbauteil, nach dem Sintern.

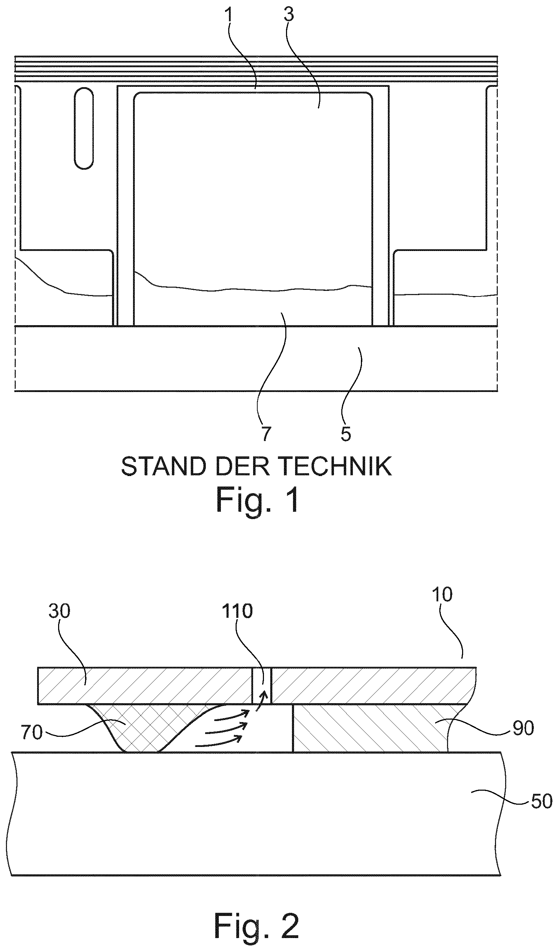

In Figur 1 wird eine Draufsicht auf eine aus dem Stand der Technik bekannte Substratanordnung 1 verbunden mit einem Elektronikbauteil 5 gezeigt. In Figur 1 wird das Elektronikbauteil 5 als Leistungshalbleiter gezeigt und die Substratanordnung 3 ist auf einem Kontakt des Elektronikbauteils 5 angeordnet, um eine Kontaktierung des Kontakts mittels eines Bonddrahtes zu ermöglichen.

Auf der nicht gezeigten ersten Seite des Substrats 3 wurde vor dem Verbinden mit dem Elektronikbauteil 5 eine Kontaktierungsmittelschicht und ein Vorfixiermittel angeordnet und nach dem Anordnen mit dem Elektronikbauteil 5 gesintert. Die sich durch die Temperatur- und/oder Druckbehandlung verflüssigten Anteile oder Reste des Vorfixiermittels 7 sind auf der zweiten Seite des Substrats 3 und auf benachbarten Bereichen des Elektronikbauteils 5 verteilt, wie es in der Figur 1 durch eine Verfärbung gezeigt wird. Diese Anteile oder Reste des Vorfixiermittels 7 können die Sinterverbindung negativ beeinflussen, indem sie die Haltbarkeit und/oder die Lebensdauer der Sinterverbindung herabsetzen. Weiterhin verunreinigen die gezeigten seitlich ausgetretenen Anteile oder Reste des Vorfixiermittels 7 die gezeigte zweite Seite des Substrats 3, die oftmals zur Kontaktierung beispielsweise mittels mindestens eines Bonddrahtes verwendet wird, und reduziert somit den zur Verfügung stehenden Kontaktbereich und kann die Qualität der Bondverbindung herabsetzen. Auch können die auf die benachbarten Bereiche des Elektronikbauteils 5 ausgetretenen Anteile oder Reste des Vorfixiermittels 7 das Elektronikbauteil 5 zerstören.

Figur 2 zeigt eine schematische Schnittansicht einer Substratanordnung 10 gemäß einer Ausführungsform der Erfindung, die mit einem Elektronikbauteil 50 verbunden ist, vor dem Sintern.

Auf der ersten Seite des Substrats 30 sind eine Kontaktierungsmittelschicht 90 und ein Vorfixiermittel 70 angeordnet. Das Vorfixierungsmittel 70 ist in der gezeigten Ausführungsform tropfenförmig am Randbereich des Substrats 30 angeordnet, während das Vorfixiermittel 70 zur Mitte des Substrats 30 angeordnet ist. In nicht gezeigten Ausführungsformen kann das Vorfixiermittel 70 auch von der Kontaktierungsmittelschicht 90 umgeben sein oder das Vorfixiermittel 70 kann auch auf der Kontaktierungsmittelschicht 90 angeordnet sein.

In der gezeigten Ausführungsform befindet sich zwischen Vorfixiermittel 70 und Kontaktierungsmittelschicht 90 ein Abstand, so dass Vorfixiermittel 70 und Kontaktierungsmittelschicht 90 nicht in einem direkten Kontakt stehen. Weiterhin wird eine Durchgangsöffnung 110 mit einer ersten Öffnung und einer zweiten Öffnung gezeigt, die sich von der ersten Seite zur gegenüberliegenden zweiten Seite des Substrats 30 erstreckt. In der gezeigten Ausführungsform befindet sich die Durchgangsöffnung 110 in einem Bereich des Substrats 30, auf dem weder das Vorfixiermittel 70 noch die Kontaktierungsmittelschicht 90 angeordnet ist. In einer nicht gezeigten Ausführungsform kann das Vorfixiermittel 70 auch direkt an der Durchgangsöffnung 110 angeordnet sein.

Die schematisch eingezeichneten Pfeile in Figur 2 zeigen, dass Anteile oder Reste des Vorfixiermittels 70 bei einer Temperatur- und/oder Druckbehandlung, wie einem Sintervorgang, verflüssigen und gezielt in die Durchgangsöffnung 110 durch eine Kapillarwirkung der Durchgangsöffnung 110 aufgenommen werden können, um dadurch ein unkontrollierbares Austreten der Anteile oder Reste des Vorfixiermittels 70 zu vermeiden.

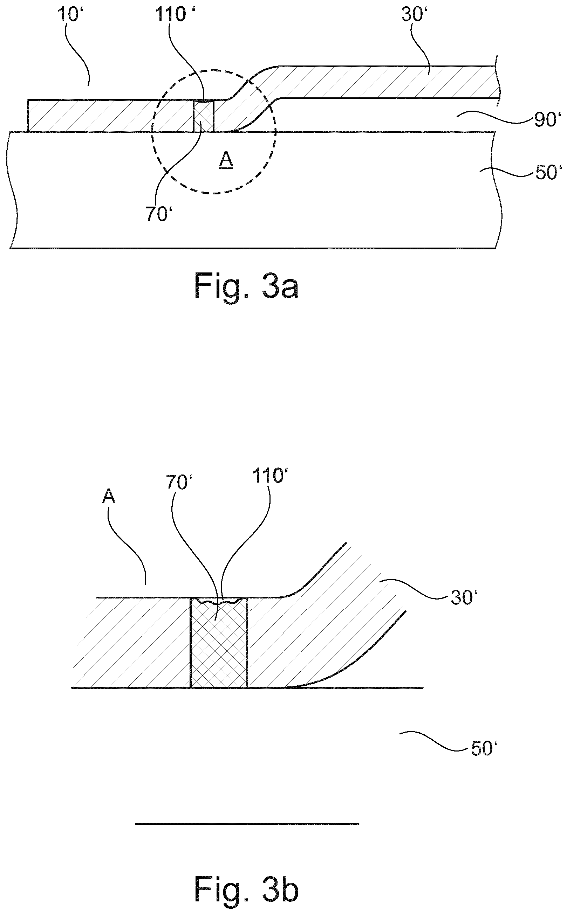

Die Figuren 3a, 3b zeigen eine schematische Schnittansicht und eine Detailansicht einer Substratanordnung 10' gemäß einer Ausführungsform der Erfindung verbunden mit einem Elektronikbauteil 50', nach dem Sintern.

Die gezeigte Substratanordnung 10' kann im Wesentlichen der in Figur 2 gezeigten Substratanordnung 10 nach dem Sintern entsprechen. Wie es in den Figuren 3a, 3b gezeigt wird, befinden sich die Anteile oder Reste des Vorfixiermittels 70', die nach dem Sintern übriggeblieben sind in der Durchgangsöffnung 110'.

Dadurch kann der unkontrollierte Austritt des Vorfixiermittels 70' während einer Temperaturund/oder Druckbehandlung zum dauerhaften Verbinden des Substrats 30' mit dem Elektronikbauteil 50' verhindert werden. Wie es in den Figuren 3a und 3b gezeigt wird, kann das Vorfixiermittel 70', das gewöhnlich während der Temperatur- und/oder Druckbehandlung in eine flüssige Phase übergeht in der Durchgangsöffnung 110' aufgenommen werden und somit räumlich festgehalten werden, so dass das Vorfixiermittel 70' innerhalb von funktionalen Stellen, wie beispielsweise auf dem Elektronikbauteil 50' oder innerhalb des Verbindungsbereichs der Kontaktierungsmittelschicht 90' zu keinen oder weniger Störungen führt.

Die in der vorstehenden Beschreibung, in den Ansprüchen und in den Figuren dargestellten Merkmale können sowohl einzeln als auch in beliebiger Kombination wesentlich für die Erfindung in ihren verschiedenen Ausführungsformen sein.

### Bezugszeichenliste

- 1: Substratanordnung - Stand der Technik
- 3: Substrat - Stand der Technik
- 5: Elektronikbauteil
- 7: Vorfixiermittel - Stand der Technik

- 10, 10': Substratanordnung
- 30, 30': Substrat
- 50, 50': Elektronikbauteil
- 70, 70': Vorfixiermittel
- 90, 90': Kontaktierungsmittelschicht
- 110, 110': Durchgangsöffnung

- A: Ausschnitt

## Patentansprüche

1. Substratanordnung zur Verbindung mit einem Elektronikbauteil (50, 50'), aufweisend:
zumindest ein Substrat (30, 30') mit einer ersten Seite und einer der ersten Seite gegenüberliegenden zweiten Seite;
zumindest eine Kontaktierungsmittelschicht (90, 90'), angeordnet zumindest abschnittsweise auf der ersten Seite des Substrats (30, 30');
zumindest ein Vorfixiermittel (70, 70'), angeordnet zumindest abschnittsweise auf einer vom Substrat (30, 30') abgewandten Seite der Kontaktierungsmittelschicht (90, 90') und/oder zumindest abschnittsweise auf der ersten Seite des Substrats (30, 30');
wobei
das Substrat (30, 30') zumindest eine Durchgangsöffnung (110, 110') mit einer ersten Öffnung und einer zweiten Öffnung von der ersten Seite zur gegenüberliegenden zweiten Seite aufweist und wobei das Vorfixiermittel eine Vorfixiermittelzusammensetzung ist,
**dadurch gekennzeichnet, dass** die Vorfixiermittelzusammensetzung die folgenden Bestandteile aufweist,
- 0 bis 97 Gew.-% mindestens eines Lösemittels ausgewählt aus der Gruppe bestehend aus Wasser und organischen Lösemitteln,
- 3 bis 100 Gew.-% mindestens eines im Bereich von 30 bis 180°C schmelzenden Materials M ausgewählt aus der Gruppe bestehend aus (i) im Bereich von 30 bis 180°C schmelzenden organischen Verbindungen, (ii) im Bereich von 30 bis 180°C schmelzenden Gemischen organischer Substanzen und (iii) organischen Polymeren,
- 0 bis 20 Gew.-% mindestens eines vom mindestens einen im Bereich von 30 bis 180°C schmelzenden Material M verschiedenen organischen freien Additivs, und
- 0 bis 30 Gew.-% eines oder mehrerer anorganischer fester Füllstoffe, wobei sich die Gew.-% zu 100 Gew.-% addieren.

2. Substratanordnung nach Anspruch 1, **dadurch gekennzeichnet, dass**
das Substrat (30, 30') eine Vielzahl von Durchgangsöffnungen (110, 110') von der ersten Seite zur gegenüberliegenden zweiten Seite aufweist, bevorzugt weist das Substrat (30, 30') Durchgangsöffnungen (110, 110') an einem Randbereich des Substrats (30, 30') auf.

3. Substratanordnung nach Anspruch 1 oder 2, **dadurch gekennzeichnet, dass**
die erste Öffnung der Durchgangsöffnung (110, 110') oder der Durchgangsöffnungen (110, 110') an der ersten Seite des Substrats (30, 30') zumindest bereichsweise an dem Vorfixiermittel (70, 70') angeordnet ist, und/oder
mit dem Vorfixiermittel (70, 70') in Verbindung steht, und/oder
zumindest bereichsweise an einem Bereich der ersten Seite des Substrats (30, 30') angeordnet ist der zumindest bereichsweise weder von dem Vorfixiermittel (70, 70') noch von der Kontaktierungsmittelschicht (90, 90') bedeckt ist.

4. Substratanordnung nach einem der vorangehenden Ansprüche,
**dadurch gekennzeichnet, dass**
die Geometrie der Durchgangsöffnung (110, 110') über den Verlauf von der ersten Öffnung zu der zweiten Öffnung im Wesentlichen konstant ausgebildet ist, oder
die Geometrie der Durchgangsöffnung (110, 110') über den Verlauf von der ersten Öffnung zu der zweiten Öffnung verkleinernd, insbesondere graduell verkleinernd, oder stufenweise verkleinernd, ausgebildet ist.

5. Substratanordnung nach einem der Ansprüche 1 bis 4, **dadurch gekennzeichnet, dass** die Durchgangsöffnung (110, 110') im Wesentlichen rechteckig ausgestaltet ist und eine Breite von 10-100µm, bevorzugt 20-70µm, aufweist, und/oder wobei ein Volumen der Durchgangsöffnung (110, 110') mindestens 5% des Volumens des Vorfixiermittels (70, 70') beträgt.

6. Substratanordnung nach einem der vorangehenden Ansprüche, **dadurch gekennzeichnet, dass**
die Kontaktierungsmittelschicht (90, 90') Metallpartikel, insbesondere Silberpartikel, umfasst.

7. Substratanordnung nach einem der vorangehenden Ansprüche, **dadurch gekennzeichnet, dass**
die Kontaktierungsmittelschicht (90, 90') auf einer Fläche der ersten Seite des Substrats (30, 30') angeordnet ist, und einen kontaktierungsmittelfreien Bereich, insbesondere einen Rand, auf der ersten Seite des Substrats (30, 30') ausbildet, der frei von der Kontaktierungsmittelschicht ist, und
das Vorfixiermittel (70, 70') zumindest abschnittsweise auf dem kontaktierungsmittelfreien Bereich angeordnet, insbesondere punktförmig angeordnet, ist.

8. Substratanordnung nach einem der vorangehenden Ansprüche, **dadurch gekennzeichnet, dass**
das Substrat (30, 30') ein Metallblech oder Metallbandabschnitt, insbesondere ein Kupferblech oder ein Kupferblechabschnitt, oder ein Leadframe oder ein DCB - oder PCB -Substrat umfasst, und/oder
das Substrat (30, 30') auf der ersten und/oder zweiten Seite mit einem Material das Gold (Au), Nickel-Gold (NiAu), Silber (Ag), Nickel-Silber (NiAg) und/oder Nickel-Palladium-Gold (NiPdAu) umfasst beschichtet, insbesondere galvanisiert oder chemisch abgeschieden, ist.

9. Verfahren zur Herstellung einer Substratanordnung zur Verbindung mit einem Elektronikbauteil (50, 50'), aufweisend die Schritte:
Bereitstellen zumindest eines Substrats (30, 30') mit einer ersten Seite und einer der ersten Seite gegenüberliegenden zweiten Seite, wobei das Substrat (30, 30') zumindest eine Durchgangsöffnung (110, 110') mit einer ersten Öffnung und einer zweiten Öffnung von der ersten Seite zur gegenüberliegenden zweiten Seite aufweist; Aufbringen zumindest einer Kontaktierungsmittelschicht (90, 90') zumindest abschnittsweise auf der ersten Seite des Substrats (30, 30'); und
Aufbringen zumindest eines Vorfixiermittels (70, 70') zumindest abschnittsweise auf einer vom Substrat (30, 30') abgewandten Seite der Kontaktierungsmittelschicht (90, 90') und/oder Aufbringen des Vorfixiermittels (70, 70') zumindest abschnittsweise auf der ersten Seite des Substrats (30, 30')
und wobei das Vorfixiermittel eine Vorfixiermittelzusammensetzung ist,
**dadurch gekennzeichnet, dass** die Vorfixiermittelzusammensetzung die folgenden Bestandteile aufweist,
- 0 bis 97 Gew.-% mindestens eines Lösemittels ausgewählt aus der Gruppe bestehend aus Wasser und organischen Lösemitteln,
- 3 bis 100 Gew.-% mindestens eines im Bereich von 30 bis 180°C schmelzenden Materials M ausgewählt aus der Gruppe bestehend aus (i) im Bereich von 30 bis 180°C schmelzenden organischen Verbindungen, (ii) im Bereich von 30 bis 180°C schmelzenden Gemischen organischer Substanzen und (iii) organischen Polymeren,
- 0 bis 20 Gew.-% mindestens eines vom mindestens einen im Bereich von 30 bis 180°C schmelzenden Material M verschiedenen organischen freien Additivs, und
- 0 bis 30 Gew.-% eines oder mehrerer anorganischer fester Füllstoffe,
wobei sich die Gew.-% zu 100 Gew.-% addieren.

10. Verfahren nach Anspruch 9, **dadurch gekennzeichnet, dass**
das Bereitstellen des Substrats (30, 30') aufweist:
Einbringen zumindest einer, bevorzugt einer Vielzahl von, Durchgangsöffnungen (110, 110'), insbesondere durch Ätzen, Stanzen und/oder einem Laser/Wasserstrahl, von der ersten Seite des Substrats (30, 30') zur gegenüberliegenden zweiten Seite des Substrats (30, 30'), bevorzugt Einbringen der Durchgangsöffnungen (110, 110') an einem Randbereich des Substrats (30, 30').

11. Verfahren nach Anspruch 9 oder 10, **dadurch gekennzeichnet, dass**
die erste Öffnung der Durchgangsöffnung oder der Durchgangsöffnungen (110, 110') an der ersten Seite des Substrats (30, 30') zumindest bereichsweise an dem Vorfixiermittel (70, 70') angeordnet ist, und/oder
mit dem Vorfixiermittel (70, 70') in Verbindung steht, und/oder
zumindest bereichsweise an einem Bereich der ersten Seite des Substrats (30, 30') angeordnet ist der zumindest bereichsweise weder von dem Vorfixiermittel (70, 70') noch von der Kontaktierungsmittelschicht (90, 90') bedeckt ist.

12. Verfahren nach einem der Ansprüche 9 bis 11, **dadurch gekennzeichnet, dass**
die Geometrie der Durchgangsöffnung (110, 110') über den Verlauf von der ersten Öffnung zu der zweiten Öffnung im Wesentlichen konstant ausgebildet ist, oder
die Geometrie der Durchgangsöffnung (110, 110') über den Verlauf von der ersten Öffnung zu der zweiten Öffnung verkleinernd, insbesondere graduell verkleinernd, oder stufenweise verkleinernd, ausgebildet ist.

13. Verfahren nach einem der Ansprüche 9 bis 12, **dadurch gekennzeichnet, dass**
die Durchgangsöffnung (110, 110') im Wesentlichen rechteckig ausgestaltet ist und eine Breite von 10-100µm, bevorzugt 20-70µm, aufweist, und/oder wobei ein Volumen der Durchgangsöffnung (110, 110') mindestens 5% des Volumens des Vorfixiermittels (70, 70') beträgt.

14. Verfahren zum Verbinden mindestens eines Elektronikbauteils (50, 50') mit einer Substratanordnung nach einem der Ansprüche 6 bis 8 oder mit einer Substratanordnung hergestellt nach einem der Ansprüche 9 bis 13, aufweisend die Schritte:
Positionieren der Substratanordnung auf dem Elektronikbauteil (50, 50') mit der ersten Seite in Richtung des Elektronikbauteils (50, 50');
Vorfixieren der Substratanordnung auf dem Elektronikbauteil (50, 50') durch das Vorfixiermittel (70, 70') auf der ersten Seite des Substrats (30, 30'); und
Verbinden der Substratanordnung mit dem mindestens einen Elektronikbauteil (50, 50').

15. Verfahren nach Anspruch 14, **dadurch gekennzeichnet, dass**
das Verbinden aufweist:
Versintern, Verpressen, Verlöten, und/oder Verkleben der Substratanordnung mit dem Elektronikbauteil (50, 50'), wobei während dem Verbinden Anteile oder Reste des Vorfixiermittels (70, 70') in die Durchgangsöffnung (110, 110') des Substrats (30, 30') aufgenommen werden, und/oder aus der Durchgangsöffnung (110, 110') auf der zweiten Seite des Substrats (30, 30') hindurchtreten.

## Claims

1. A substrate arrangement for connection to an electronic component (50, 50'), comprising:
at least one substrate (30, 30') having a first side and a second side opposite the first side;
at least one contacting agent layer (90, 90'), arranged at least in portions on the first side of the substrate (30, 30');
at least one pre-fixing agent (70, 70'), arranged at least in portions on a side of the contacting agent layer (90, 90') that faces away from the substrate (30, 30') and/or at least in portions on the first side of the substrate (30, 30');
the substrate (30, 30') comprising at least one through-opening (110, 110') having a first opening and a second opening from the first side to the opposite second side and the pre-fixing agent being a pre-fixing agent composition,
**characterized in that** the pre-fixing agent composition comprises the following constituents:
- 0 to 97 wt.% of at least one solvent selected from the group consisting of water and organic solvents,
- 3 to 100 wt.% of at least one material M which melts in the range of 30 to 180°C, selected from the group consisting of (i) organic compounds which melt in the range of 30 to 180°C, (ii) mixtures of organic substances which melt in the range of 30 to 180°C and (iii) organic polymers,
- 0 to 20 wt.% of at least one organic free additive which is different from at least one material M which melts in the range of 30 to 180°C, and
- 0 to 30 wt.% of one or more inorganic solid fillers,
the wt.% values adding up to 100 wt.%.

2. The substrate arrangement according to claim 1, **characterized in that**
the substrate (30, 30') comprises a plurality of through-openings (110, 110') from the first side to the opposite second side, preferably the substrate (30, 30') comprises through-openings (110, 110') at an edge region of the substrate (30, 30').

3. The substrate arrangement according to claim 1 or claim 2, **characterized in that**
the first opening of the through-opening (110, 110') or through-openings (110, 110') on the first side of the substrate (30, 30') is arranged at least partially on the pre-fixing agent (70, 70'), and/or
is in contact with the pre-fixing agent (70, 70'), and/or
is arranged at least partially at a region of the first side of the substrate (30, 30') that is at least partially neither covered by the pre-fixing agent (70, 70') nor by the contacting agent layer (90, 90').

4. The substrate arrangement according to any of the preceding claims,
**characterized in that**
the geometry of the through-opening (110, 110') is substantially constant over the path from the first opening to the second opening, or
the geometry of the through-opening (110, 110') is designed to decrease in size over the path from the first opening to the second opening, in particular to decrease gradually or to decrease stepwise.

5. The substrate arrangement according to any of claims 1 to 4, **characterized in that** the through-opening (110, 110') is substantially rectangular and has a width of 10-100 µm, preferably 20-70 µm, and/or wherein a volume of the through-opening (110, 110') is at least 5% of the volume of the pre-fixing agent (70, 70').

6. The substrate arrangement according to any of the preceding claims, **characterized in that** the contacting agent layer (90, 90') comprises metal particles, in particular silver particles.

7. The substrate arrangement according to any of the preceding claims, **characterized in that** the contacting agent layer (90, 90') is arranged on a surface of the first side of the substrate (30, 30') and forms a contacting agent-free region, in particular an edge, on the first side of the substrate (30, 30'), which region is free from the contacting agent layer, and
the pre-fixing agent (70, 70') is arranged at least in portions on the contacting agent-free region, in particular arranged in a point-like manner.

8. The substrate arrangement according to any of the preceding claims, **characterized in that** the substrate (30, 30') comprises a metal sheet or metal strip portion, in particular a copper sheet or a copper sheet portion, or a leadframe or a DCB substrate or PCB substrate, and/or the substrate (30, 30') is coated on the first and/or second side with a material comprising gold (Au), nickel-gold (NiAu), silver (Ag), nickel-silver (NiAg) and/or nickel-palladium-gold (NiPdAu), in particular galvanized or chemically deposited.

9. A method for manufacturing a substrate arrangement for connection to an electronic component (50, 50'), comprising the steps of:
providing at least one substrate (30, 30') having a first side and a second side opposite the first side, the substrate (30, 30') comprising at least one through-opening (110, 110') having a first opening and a second opening from the first side to the opposite second side; applying at least one contacting agent layer (90, 90') at least in portions to the first side of the substrate (30, 30'); and
applying at least one pre-fixing agent (70, 70') at least in portions to a side of the contacting agent layer (90, 90') that faces away from the substrate (30, 30') and/or applying the pre-fixing agent (70, 70') at least in portions to the first side of the substrate (30, 30') and the pre-fixing agent being a pre-fixing agent composition,
**characterized in that** the pre-fixing agent composition comprises the following constituents:
- 0 to 97 wt.% of at least one solvent selected from the group consisting of water and organic solvents,
- 3 to 100 wt.% of at least one material M which melts in the range of 30 to 180°C, selected from the group consisting of (i) organic compounds which melt in the range of 30 to 180°C, (ii) mixtures of organic substances which melt in the range of 30 to 180°C and (iii) organic polymers,
- 0 to 20 wt.% of at least one organic free additive which is different from at least one material M which melts in the range of 30 to 180°C, and
- 0 to 30 wt.% of one or more inorganic solid fillers, the wt.% values adding up to 100 wt.%.

10. The method according to claim 9, **characterized in that**
providing the substrate (30, 30') comprises:
introducing at least one, preferably a plurality of through-openings (110, 110'), in particular by etching, punching out and/or a laser/water jet, from the first side of the substrate (30, 30') to the opposite second side of the substrate (30, 30'), preferably introducing the through-openings (110, 110') at an edge region of the substrate (30, 30').

11. The method according to claim 9 or claim 10, **characterized in that**
the first opening of the through-opening or through-openings (110, 110') on the first side of the substrate (30, 30') is arranged at least partially on the pre-fixing agent (70, 70'), and/or is in contact with the pre-fixing agent (70, 70'), and/or
is arranged at least partially at a region of the first side of the substrate (30, 30') that is at least partially neither covered by the pre-fixing agent (70, 70') nor by the contacting agent layer (90, 90').

12. The method according to any of claims 9 to 11, **characterized in that**
the geometry of the through-opening (110, 110') is substantially constant over the path from the first opening to the second opening, or
the geometry of the through-opening (110, 110') is designed to decrease in size over the path from the first opening to the second opening, in particular to decrease gradually or to decrease stepwise.

13. The method according to any of claims 9 to 12, **characterized in that** the through-opening (110, 110') is substantially rectangular and has a width of 10-100 µm, preferably 20-70 µm, and/or wherein a volume of the through-opening (110, 110') is at least 5% of the volume of the pre-fixing agent (70, 70').

14. A method for connecting at least one electronic component (50, 50') to a substrate arrangement according to any of claims 6 to 8 or to a substrate arrangement manufactured according to any of claims 9 to 13, comprising the steps of:
positioning the substrate arrangement on the electronic component (50, 50') so that the first side faces the electronic component (50, 50');
pre-fixing the substrate arrangement onto the electronic component (50, 50') on the first side of the substrate (30, 30') by means of the pre-fixing agent (70, 70'); and
connecting the substrate arrangement to the at least one electronic component (50, 50').

15. The method according to claim 14, **characterized in that**
connecting comprises:
sintering, pressing, soldering, and/or bonding the substrate arrangement to the electronic component (50, 50'), and, during connection, portions or residues of the pre-fixing agent (70, 70') being absorbed into the through-opening (110, 110') of the substrate (30, 30'), and/or
passing through the through-opening (110, 110') on the second side of the substrate (30, 30').

## Revendications

1. Agencement de substrat pour la liaison à un composant électronique (50, 50'), présentant :
au moins un substrat (30, 30') comportant une première face et une seconde face opposée à la première face ;
au moins une couche d'agent de mise en contact (90, 90') disposée, au moins dans certaines sections, sur la première face du substrat (30, 30') ;
au moins un agent de préfixation (70, 70') disposé, au moins dans certaines sections, sur une face de la couche d'agent de mise en contact (90, 90') opposée au substrat (30, 30') et/ou, au moins dans certaines sections, sur la première face du substrat (30, 30') ;
dans lequel le substrat (30, 30') présente au moins une ouverture de passage (110, 110') comportant une première ouverture et une seconde ouverture depuis la première face jusqu'à la seconde face opposée, et dans lequel l'agent de préfixation est une composition d'agent de préfixation,
**caractérisé en ce que** la composition d'agent de préfixation présente les ingrédients suivants,
- 0 à 97 % en poids d'au moins un solvant choisi dans le groupe constitué d'eau et de solvants organiques,
- 3 à 100 % en poids d'au moins un matériau M fondant dans la plage allant de 30 à 180 °C, choisi dans le groupe constitué de (i) composés organiques fondant dans la plage allant de 30 à 180 °C, (ii) mélanges de substances organiques fondant dans la plage allant de 30 à 180 °C et (iii) polymères organiques,
- 0 à 20 % en poids d'au moins un additif libre organique différent de l'au moins un matériau M fondant dans la plage allant de 30 à 180 °C, et
- 0 à 30 % en poids d'une ou de plusieurs charges solides inorganiques,
dans lequel les % en poids s'additionnent pour donner 100 % en poids.

2. Agencement de substrat selon la revendication 1, **caractérisé en ce que**
le substrat (30, 30') présente une pluralité d'ouvertures de passage (110, 110') depuis la première face jusqu'à la seconde face opposée, de préférence le substrat (30, 30') présente des ouvertures de passage (110, 110') sur une zone de bord du substrat (30, 30').

3. Agencement de substrat selon la revendication 1 ou 2, **caractérisé en ce que**
la première ouverture de l'ouverture de passage (110, 110') ou des ouvertures de passage (110, 110') sur la première face du substrat (30, 30') est disposée, au moins dans certaines zones, sur l'agent de préfixation (70, 70'), et/ou
est en liaison avec l'agent de préfixation (70, 70'), et/ou
est disposée, au moins dans certaines zones, sur une zone de la première face du substrat (30, 30') qui n'est recouverte, au moins dans certaines zones, ni par l'agent de préfixation (70, 70'), ni par la couche d'agent de mise en contact (90, 90').

4. Agencement de substrat selon l'une des revendications précédentes,
**caractérisé en ce que**
la géométrie de l'ouverture de passage (110, 110') est réalisée de manière à être sensiblement constante sur le tracé allant de la première ouverture à la seconde ouverture, ou
la géométrie de l'ouverture de passage (110, 110') est réalisée de manière à se réduire sur le tracé allant de la première ouverture à la seconde ouverture, en particulier de manière à se réduire graduellement, ou de manière à se réduire progressivement.

5. Agencement de substrat selon l'une des revendications 1 à 4, **caractérisé en ce que** l'ouverture de passage (110, 110') est conçue sous forme sensiblement rectangulaire et présente une largeur allant de 10 à 100 µm, de préférence de 20 à 70 µm, et/ou dans lequel un volume de l'ouverture de passage (110, 110') représente au moins 5 % du volume de l'agent de préfixation (70, 70').

6. Agencement de substrat selon l'une des revendications précédentes, **caractérisé en ce que** la couche d'agent de mise en contact (90, 90') comprend des particules métalliques, en particulier des particules d'argent.

7. Agencement de substrat selon l'une des revendications précédentes, **caractérisé en ce que** la couche d'agent de mise en contact (90, 90') est disposée sur une surface de la première face du substrat (30, 30') et forme sur la première face du substrat (30, 30') une zone exempte d'agent de mise en contact, en particulier un bord, qui est exempt de la couche d'agent de mise en contact, et
l'agent de préfixation (70, 70') est disposé, au moins dans certaines sections, sur la zone exempte d'agent de mise en contact, en particulier est disposé de manière ponctuelle.

8. Agencement de substrat selon l'une des revendications précédentes, **caractérisé en ce que** le substrat (30, 30') comprend une tôle métallique ou une section formant bande métallique, en particulier une tôle de cuivre ou une section formant tôle de cuivre, ou un cadre de montage ou un substrat DCB ou PCB, et/ou
le substrat (30, 30') est revêtu, en particulier par galvanisation ou par dépôt chimique, sur la première et/ou la seconde face, d'un matériau comprenant de l'or (Au), du nickelor (NiAu), de l'argent (Ag), du nickel-argent (NiAg) et/ou du nickel-palladium-or (NiPdAu).

9. Procédé pour la fabrication d'un agencement de substrat pour la liaison à un composant électronique (50, 50'), présentant les étapes consistant à :
fournir au moins un substrat (30, 30') comportant une première face et une seconde face opposée à la première face, dans lequel le substrat (30, 30') présente au moins une ouverture de passage (110, 110') comportant une première ouverture et une seconde ouverture depuis la première face jusqu'à la seconde face opposée ; appliquer au moins une couche d'agent de mise en contact (90, 90'), au moins dans certaines sections, sur la première face du substrat (30, 30') ; et
appliquer au moins un agent de préfixation (70, 70'), au moins dans certaines sections, sur une face de la couche d'agent de mise en contact (90, 90') opposée au substrat (30, 30') et/ou appliquer l'agent de préfixation (70, 70'), au moins dans certaines sections, sur la première face du substrat (30, 30')
et dans lequel l'agent de préfixation est une composition d'agent de préfixation,
**caractérisé en ce que** la composition d'agent de préfixation présente les ingrédients suivants,
- 0 à 97 % en poids d'au moins un solvant choisi dans le groupe constitué d'eau et de solvants organiques,
- 3 à 100 % en poids d'au moins un matériau M fondant dans la plage allant de 30 à 180 °C, choisi dans le groupe constitué de (i) composés organiques fondant dans la plage allant de 30 à 180 °C, (ii) mélanges de substances organiques fondant dans la plage allant de 30 à 180 °C et (iii) polymères organiques,
- 0 à 20 % en poids d'au moins un additif libre organique différent de l'au moins un matériau M fondant dans la plage allant de 30 à 180 °C, et
- 0 à 30 % en poids d'une ou de plusieurs charges solides inorganiques, dans lequel les % en poids s'additionnent pour donner 100 % en poids.

10. Procédé selon la revendication 9, **caractérisé en ce que**
la fourniture du substrat (30, 30') présente :
l'introduction d'au moins une ouverture de passage, de préférence d'une pluralité d'ouvertures de passage (110, 110'), en particulier par gravure, estampage et/ou laser/jet d'eau, depuis la première face du substrat (30, 30') jusqu'à la seconde face opposée du substrat (30, 30'), de préférence l'introduction des ouvertures de passage (110, 110') sur une zone de bord du substrat (30, 30').

11. Procédé selon la revendication 9 ou 10, **caractérisé en ce que**
la première ouverture de l'ouverture de passage ou des ouvertures de passage (110, 110') sur la première face du substrat (30, 30') est disposée, au moins dans certaines zones, sur l'agent de préfixation (70, 70'), et/ou
est en liaison avec l'agent de préfixation (70, 70'), et/ou
est disposée, au moins dans certaines zones, sur une zone de la première face du substrat (30, 30') qui n'est recouverte, au moins dans certaines zones, ni par l'agent de préfixation (70, 70'), ni par la couche d'agent de mise en contact (90, 90').

12. Procédé selon l'une des revendications 9 à 11, **caractérisé en ce que**
la géométrie de l'ouverture de passage (110, 110') est réalisée de manière à être sensiblement constante sur le tracé allant de la première ouverture à la seconde ouverture, ou
la géométrie de l'ouverture de passage (110, 110') est réalisée de manière à se réduire sur le tracé allant de la première ouverture à la seconde ouverture, en particulier de manière à se réduire graduellement, ou de manière à se réduire progressivement.

13. Procédé selon l'une des revendications 9 à 12, **caractérisé en ce que**
l'ouverture de passage (110, 110') est conçue de manière à être sensiblement rectangulaire et présente une largeur allant de 10 à 100 µm, de préférence de 20 à 70 µm, et/ou dans lequel un volume de l'ouverture de passage (110, 110') représente au moins 5 % du volume de l'agent de préfixation (70, 70').

14. Procédé pour la liaison d'au moins un composant électronique (50, 50') à un agencement de substrat selon l'une des revendications 6 à 8 ou à un agencement de substrat fabriqué selon l'une des revendications 9 à 13, présentant les étapes consistant à :
positionner l'agencement de substrat sur le composant électronique (50, 50') avec la première face en direction du composant électronique (50, 50') ;
préfixer l'agencement de substrat sur le composant électronique (50, 50') au moyen de l'agent de préfixation (70, 70') sur la première face du substrat (30, 30') ; et
relier l'agencement de substrat à l'au moins un composant électronique (50, 50').

15. Procédé selon la revendication 14, **caractérisé en ce que**
la liaison présente :
le frittage, pressage, brasage, et/ou collage de l'agencement de substrat avec le composant électronique (50, 50'), dans lequel, pendant la liaison, des parties ou des restes de l'agent de préfixation (70, 70') sont absorbés dans l'ouverture de passage (110, 110') du substrat (30, 30'), et/ou passent à travers l'ouverture de passage (110, 110') sur la seconde face du substrat (30, 30').
